# EUROPÄISCHE PATENTSCHRIFT

(11) **EP 4 031 944 B1**
(45) Veröffentlichungstag und Bekanntmachung des Hinweises auf die Patenterteilung: **04.10.2023**
(21) Anmeldenummer: 20761199.7
(22) Anmeldetag: 20.08.2020
(51) Int. Cl.: G05B 19/042

(54) **FELDGERÄT**
FIELD DEVICE
APPAREIL DE TERRAIN

(30) Priorität: 18.09.2019 DE 102019125150
(43) Veröffentlichungstag der Anmeldung: 27.07.2022
(73) Patentinhaber: Endress+Hauser Wetzer GmbH+Co. KG, 87484 Nesselwang (DE)
(72) Erfinder: WALSER, Björn, 87534 Oberstaufen (DE); LUGLI, Roberto, 20090 Segrate (IT); SCHNALKE, Michael, 87484 Nesselwang (DE); SCHMÖLZ, Fabian, 87669 Rieden am Forggensee (DE)
(74) Vertreter: Koslowski, Christine Adelheid
(86) Internationale Anmeldenummer: PCT/EP2020/073408
(87) Internationale Veröffentlichungsnummer: WO 2021/052710

(56) Entgegenhaltungen:
- DE-A1-102017 201 166
- US-B2- 7 885 610

## Beschreibung

Die Erfindung betrifft ein Feldgerät mit einer sicheren Schnittstelle und ein entsprechendes Verfahren zum Betrieb dieses Feldgerätes.

In der Automatisierungstechnik, insbesondere in der Prozessautomatisie-rungstechnik, werden vielfach Feldgeräte eingesetzt, die zur Erfassung und/oder zur Beeinflussung verschiedener Messgrößen dienen. Bei der zu bestimmenden Messgröße kann es sich beispielsweise um einen Füllstand, einen Durchfluss, einen Druck, die Temperatur, der pH-Wert, das Redoxpotential, eine Leitfähigkeit oder der Dielektrizitätswert eines Mediums handeln. Zur Erfassung der entsprechenden Messwerte umfassen die Feldgeräte jeweils geeignete Sensoren bzw. basieren auf geeigneten Messprinzipien. Eine Vielzahl dieser Feldgeräte wird von der Firma Endress + Hauser hergestellt und vertrieben.

Zur Übertragung der Messwerte vom Feldgerät an eine übergeordnete Einheit, beispielsweise an eine Prozessleitstelle, sind in der Automatisierungstechnik historisch bedingt Einheitssignale nach dem 4-20mA Standard nach wie vor weit verbreitet. Durch solch analoge Signale kann eine sichere und einfache Datenübertragung des jeweiligen Messwertes gewährleistet werden. Im Falle des 4-20 mA Standards (wie in der Norm DIN IEC 60381-1 definiert ist) wird der auf jeweils einer Hin- und Rückleitung fließende Gleichstrom so eingestellt, dass er den aktuellen Wert der Prozessgröße repräsentiert. Im Falle eines spannungsbasierten Einheitssignals wird zwischen der Hin- und Rückleitung ein entsprechender Spannungswert abgegriffen. Handelt es sich um ein Zweidraht-Feldgerät, so erfolgen die Energie-Versorgung des Feldgerätes und die Übertragung des Einheitssignals über die gleiche Zweidrahtleitung. Bei einer Vierdraht-Schnittstelle erfolgt die Energie-Versorgung separat über die zwei zusätzlichen Leitungen. Ein Feldgerät mit einer 4-20 mA Schnittstelle wird beispielsweise in der Veröffentlichungsschrift DE 10 2013 114 377 A1 gezeigt.

In modernen Prozessanlagen erfolgt die Übertragung von Messwerten bzw. die Kommunikation mit Feldgeräten allgemein mittlerweile zunehmend auch auf Basis digitaler Übertragungs-Standards, wie beispielsweise "IO-Link" gemäß der IEC-Norm 61131-9, "PROFIBUS", "HART", "Wireless HART" oder auch "Ethernet". Dementsprechend müssen moderne Feldgeräte eine Schnittstelle umfassen, über die der Messwert sowohl nach analogen Standards wie 4-20 mA übertragen werden kann, über die jedoch auch digitale Kommunikation mittels entsprechender Standards durchgeführt werden kann.

Feldgeräte mit entsprechenden Schnittstellen sind kommerziell bereits verfügbar. Hierbei muss dem Feldgerät vor Inbetriebnahme mitgeteilt werden, gemäß welchem Standard der Messwert übertragen werden soll. In diesem Zusammenhang ist bei mehrpoligen Schnittstellen wie M12-Steckverbindungen außerdem vorab festzulegen, über welche Kontakte der Schnittstelle bzw. mittels welchen Standards der Messwert zu übertragen ist. Dementsprechend ist bei einer Umverdrahtung des Feldgerätes, beispielsweise im Rahmen eines neuen Einsatzortes, das Feldgerät gegebenenfalls wiederum auch auf den zukünftig zu verwendenden Übertragungsstandard einzustellen. Geschieht dies nicht, so besteht insbesondere bei analogen Übertragungs-Standards das Risiko, dass das übertragene Signal zu einer falschen Interpretation des Messwertes seitens der übergeordneten Einheit führt. Je nach Art des Prozesses kann dies eine gefährliche Situation in der Prozessanlage herbeiführen, wie beispielsweise eine Überhitzung, eine Überfüllung oder eine Übersäuerung eines Mediums.

Der Erfindung liegt dementsprechend die Aufgabe zugrunde, eine Feldgerät mit einer sicheren Schnittstelle bereitzustellen.

Die Erfindung löst diese Aufgabe durch ein Feldgerät zur Messung einer Messgröße, das zumindest folgende Komponenten umfasst:
- Einen Sensor, der ausgelegt ist, den entsprechenden Messwert zu messen,
- eine Schnittstelle mit zumindest vier elektrischen Kontakten, wie beispielsweise einem M12 Steckkontakt,
- einen ersten Stromregler, der ausgelegt ist, um
   o einen ersten Strom zwischen dem ersten Kontakt und dem zweiten Kontakt einzustellen, sofern das Feldgerät über die Schnittstelle so kontaktiert ist, dass zwischen diesen Kontakten eine erste Spannungsquelle angeschlossen ist,
dadurch gekennzeichnet, dass das Feldgerät weiter umfasst
- einen zweiten Stromregler, der ausgelegt ist,
   o einen zweiten Strom zwischen dem ersten Kontakt und dem dritten Kontakt einzustellen, sofern das Feldgerät über die Schnittstelle so kontaktiert ist, dass zwischen diesen Kontakten eine zweite elektrische Spannungsquelle angeschlossen ist,
   o im anderen Fall ein zweites Signal zu generieren, und
- eine Steuer-Einheit, die ausgelegt ist,
   o den Messwert gemäß einem vordefinierten digitalen Standard, insbesondere dem IO-Link Standard über den vierten Kontakt zu übertragen, sofern der zweite Strom zwischen dem ersten Kontakt und dem dritten Kontakt einstellbar ist, und
   o den ersten Stromregler derart zu steuern, dass die Stromstärke des ersten Stroms dem Messwert gemäß einem vordefinierten Stromsignal-Standard (insbesondere dem 4-20 mA Standard) entspricht, sofern der zweite Stromregler das zweite Signal generiert.

Dabei wird unter dem Begriff "*Einheit"* im Rahmen der Erfindung prinzipiell jede elektronische Schaltung verstanden, die für den angedachten Einsatzzweck geeignet ausgelegt ist. Es kann sich also je nach Anforderung um eine Analogschaltung zur Erzeugung bzw. Verarbeitung entsprechender analoger Signale handeln. Es kann sich jedoch auch um eine Digitalschaltung wie einem FPGA oder einen Speichermedium in Zusammenwirken mit einem Programm handeln. Dabei ist das Programm ausgelegt, die entsprechenden Verfahrensschritte durchzuführen bzw. die notwendigen Rechenoperationen der jeweiligen Einheit anzuwenden. In diesem Kontext können verschiedene elektronische Einheiten des Füllstandsmessgerätes im Sinne der Erfindung potentiell auch auf einen gemeinsamen physikalischen Speicher zurückgreifen bzw. mittels derselben physikalischen Digitalschaltung betrieben werden.

Erfindungsgemäß wird durch die Implementierung zweier Stromregler ermöglicht, auf redundante Weise zu prüfen, über welche der Kontakte das Feldgerät mit der übergeordneten Einheit kontaktiert ist, so dass das Feldgerät von sich aus den hierzu passenden Übertragungs-Standard einstellen kann. Hierzu bietet es sich an, wenn der erste Stromregler ausgelegt ist, ein erstes Signal zu generieren, sofern das Feldgerät derart kontaktiert ist, dass zwischen dem ersten Kontakt und dem zweiten Kontakt keine elektrische Spannungsquelle angeschlossen ist. Auf Basis dessen kann der erste Stromregler der Steuer-Einheit mitteilen, dass der Messwert zumindest nicht per analogem Standard übertragen werden kann. Wenn der erste Stromregler zur Regelung der Stromstärke des ersten Stroms einen steuerbaren Operations-Verstärker umfasst, kann sehr leicht detektiert werden, falls der erste Strom nicht einstellbar ist, nämlich indem die Steuer-Einheit ein Steuer-Signal des Operations-Verstärkers als erstes Signal zu detektiert, sofern der Operations-Verstärker in Sättigung arbeitet.

Das erfindungsgemäße Feldgerät kann zudem so ausgelegt werden, dass je nach Kontaktierung der Schnittstelle die erste Spannungsquelle oder die zweite Spannungsquelle den ersten Stromregler, den zweiten Stromregler und/oder die Steuer-Einheit mit Leistung versorgt. Hierdurch kann auf eine separate Leistungsversorgung des Feldgerätes, wie beispielsweise mittels einer Batterie, verzichtet werden.

Korrespondierend zum erfindungsgemäßen Feldgerät nach einer der zuvor beschriebenen Ausführungsvarianten wird die Aufgabe, die der Erfindung zugrunde liegt, zudem durch ein entsprechendes Verfahren zu dessen Betrieb gelöst. Dabei umfasst das Verfahren zur Übertragung des Messwertes vom Feldgerät folgende Verfahrensschritte:
- Messung des Messwertes,
- Einstellung des zweiten Stroms zwischen dem ersten Kontakt und dem dritten Kontakt, sofern das Feldgerät über die Schnittstelle so kontaktiert ist, dass zwischen diesen Kontakten eine zweite elektrische Spannungsquelle angeschlossen ist, und andernfalls
- Generierung des zweiten Signals,
- Übertragung des Messwertes gemäß dem vordefinierten digitalen Protokoll über den vierten Kontakt, sofern das zweite Signal nicht generiert wird,
- Einstellung des ersten Stroms zwischen dem ersten Kontakt und dem zweiten Kontakt, sofern das Feldgerät über die Schnittstelle so kontaktiert ist, dass zwischen diesen Kontakten eine erste elektrische Spannungsquelle angeschlossen ist, und andernfalls
- Generierung des ersten Signals,
wobei die Verfahrensschritte zumindest dann zyklisch wiederholt werden, sofern das erste Signal nicht generiert wird. Im anderen Fall wird lediglich die Messung des Messwertes, die Übertragung des Messwertes gemäß dem vordefinierten digitalen Protokoll über den vierten Kontakt, die Einstellung des ersten Stroms und die etwaige Generierung des ersten Signals wiederholt werden.

Durch das Verfahren sowie dessen zyklischer Wiederholung wird sichergestellt, dass das Feldgerät eine Änderung der Kontaktierung auch während des Messbetriebs feststellen und automatisch reagieren kann, ohne dass die Konfiguration des Feldgerätes manuell geändert werden muss. Hierdurch erhöht sich die Sicherheit der Prozess-Anlage, da eine etwaige Fehlinterpretation der übermittelten Signale seitens der übergeordneten Einheit vermieden werden.

Sofern das zweite Signal generiert wird, kann das Verfahren um folgenden VerfahrensSchritt erweitert werden:
- Derartige Steuerung des ersten Stromreglers, so dass die Stromstärke des ersten Stroms (a₁) gemäß dem vordefinierten Stromsignal-Standard dem Messwert entspricht,

Dabei werden wiederum die gesamten Verfahrensschritte zyklisch wiederholt, sofern nach Ansteuerung des ersten Stromreglers das erste Signal generiert wird. m anderen Fall werden lediglich die Messung des Messwertes und die Steuerung des ersten Stromreglers, so dass die Stromstärke des ersten Stroms gemäß dem vordefinierten Stromsignal-Standard dem Messwert entspricht, wiederholt. Hierdurch kann das Feldgerät selbstständig erkennen, ob die Verkabelung zur übergeordneten Einheit gewechselt wurde und somit eine Neu-Konfiguration der Schnittstelle erforderlich ist.

Damit eine erforderliche Neukonfiguration der Schnittstelle im Zweifelsfall schnell detektierbar ist, ist es im Rahmen der Erfindung vorteilhaft, wenn der erste Strom maximal 300 ms, nachdem der zweite Stromregler den zweiten Strom zwischen dem ersten Kontakt und dem dritten Kontakt einstellt, zwischen dem ersten Kontakt und dem zweiten Kontakt eingestellt wird. Hierdurch kann die Rate, mit der das Verfahren zyklisch wiederholt wird, entsprechend erhöht werden.

Anhand der nachfolgenden Figuren wird die Erfindung näher erläutert. Es zeigt:
Fig. 1: Ein erfindungsgemäßes Feldgerät an einem Behälter, das über eine Schnittstelle mit einer übergeordneten Einheit verbunden ist,
Fig. 2: ein Ersatzschaltbild des Feldgerätes, und
Fig. 3: ein Flowchart des erfindungsgemäßen Verfahrens zum Betrieb des Feldgerätes.

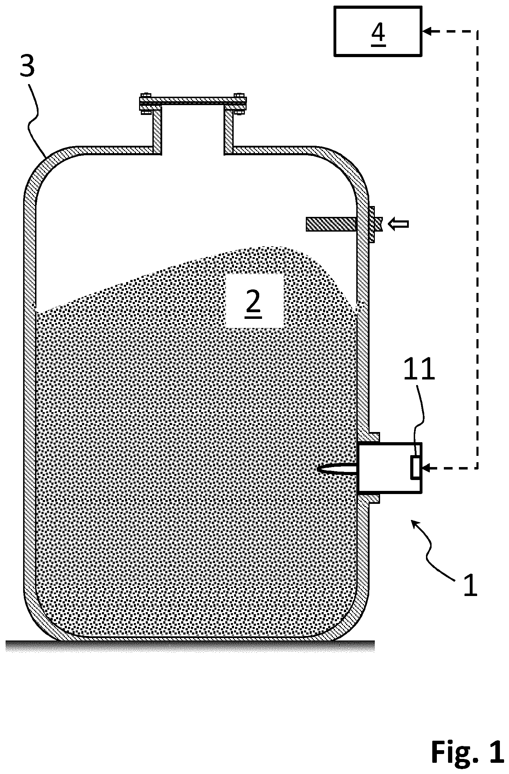

Zum allgemeinen Verständnis der Erfindung ist in Fig. 1 schematisch ein Behälter 3 gezeigt, in dem sich ein Medium 2, wie beispielsweise Chemikalien, Getreide, Zement, Wasser, Flüssiggas oder Schüttgut befindet. Zur Bestimmung einer für die Prozessanlage relevanten Messgröße, wie der Temperatur, dem Druck oder einem Füllstand, ist seitlich am Behälter 3 ein erfindungsgemäßes Feldgerät 1 angeordnet. Zur Übertragung des entsprechenden Messwertes, oder zum Austausch anderer Messgeräte-spezifischer Daten mit einer übergeordneten Einheit 4 umfasst das Feldgerät 1 eine hierzu geeignete Schnittstelle 11. Bei der übergeordneten Einheit 4 kann es sich beispielsweise um eine Prozessleitstelle zur Überwachung des Prozess-Anlage handeln.

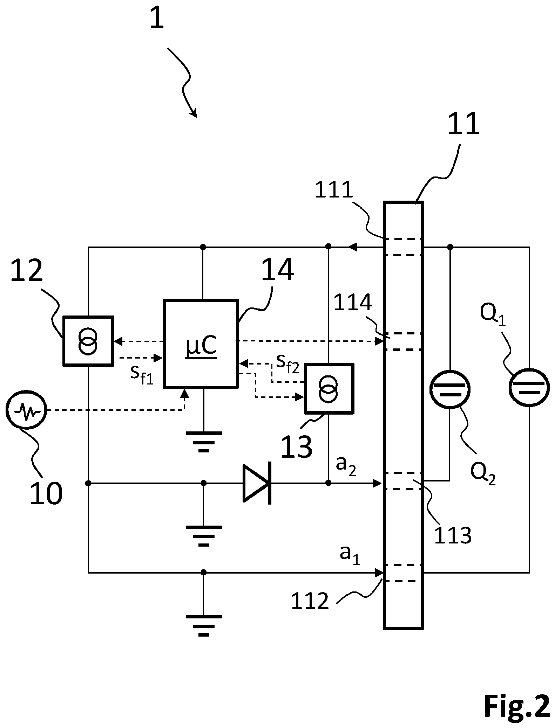

Einen gängiger Analog-Standard zur Übertragung des Messwertes bildet im Bereich der Prozessautomation der 4-20mA-Standard. Hierbei ändert sich der Wert eines ersten Gleichstroms a₁ linear mit dem Messwert. Das heißt, eine Stromstärke von 4 mA entsprechen 0 % des Messwertes. 20 mA sind äquivalent zu 100 % des Messwertes. Bei einer Füllstandsmessung beispielsweise entsprechen 4 mA also einem komplett leerem Behälter 3. 12 mA entsprechen einem zu 50 % gefüllten Behälter 3. Zu einem komplett gefüllten Behälter 3 korrespondieren 20 mA Stromstärke des Signals. Dementsprechend erfordert die Schnittstelle 11 des Feldgerätes 1 bei Implementierung des 4-20 mA Standards mindestens zwei elektrische Kontakte 111, 112, wie in Fig. 2 dargestellt ist. Der erste Strom a₁ des 4-20 mA-Signals wird hierbei durch einen ersten Stromregler 12 im Feldgerät 1 eingestellt. Der erste Stromregler 12 kann zur Regelung des ersten Stroms a₁ im einfachsten Fall auf einem Operations-Verstärker basieren, der beispielsweise als Spannungs-Stromwandler verschaltet ist. Der erste Stromregler 12 wird wiederum durch eine Steuer-Einheit 14, wie beispielsweise einem Microcontroller, mittels eines entsprechenden Steuer-Signals gesteuert. Dabei erhält die Steuer-Einheit 14 den Messwert von einem Sensor 10, der entsprechend zur Messung der jeweiligen Messgröße ausgelegt ist.

Bei der in Fig. 2 gezeigten Ausführungsvariante des Feldgerätes 1 werden sowohl die Steuer-Einheit 14 als auch der erste Stromregler 12 über die Schnittstelle 11 durch die übergeordnete Einheit 4 mit der erforderlichen Leistung versorgt. In dem Schaltbild von Fig. 2 wird diese Leistungsversorgung zwischen dem ersten Kontakt 111 und dem zweiten Kontakt 112 der Schnittstelle 11 durch eine erste Spannungsquelle Q₁ repräsentiert. Analog hierzu kann auch der Sensor 10 je nach Funktionsprinzip hierüber mit Leistung versorgt werden (nicht explizit dargestellt in Fig. 2).

Vorteilhaft am 4-20 mA-Standard ist, dass eine unterbrochene Leitung zwischen Feldgerät 1 und übergeordneter Einheit 4 leicht als Störung erkennbar ist, da der erste Strom a₁ in diesem Fall komplett unterbrochen wird. Nachteilhaft an diesem Standard sind jedoch der vergleichsweise hohe Stromverbrauch und die nur bedingt vorhandene Möglichkeit, zusätzlich zum Messwert zusätzliche Daten oder Parameter zu übertragen. Daher erfolgt die Messwert-Übertragung in modernen Prozessanlagen vermehrt rein auf digitaler Basis.

Um variabel in verschiedenen Einsatzgebieten eingesetzt werden zu können, ist die Schnittstelle 11 des Feldgerätes 1 daher flexibel ausgelegt, um neben analogen dem 4-20 mA-Standards den Messwert bzw. weitere Daten auch digitale auf Basis entsprechender Übertragungs-Standards übertragen zu können. Als Standards können hierfür beispielsweise "IO-Link" gemäß der IEC-Norm 61131-9, "PROFIBUS", "HART", "Wireless HART" oder auch "Ethernet" implementiert sein. Dementsprechend umfasst die Schnittstelle 11 des Feldgerätes 1, wie in Fig. 2 dargestellt ist, neben den zwei Kontakten 111, 112 für die 4-20 mA-basierte Messwert-Übertragung zwei weitere Kontakte 113, 114. Da der IO-Link-Standard drei Kontakte 111, 113, 114 erfordert, ist es in diesem Fall entsprechend möglich, dass die Steuer-Einheit 14 den Messwert oder andere Parameter mittels dieses Standards über den vierten Kontakt 114 überträgt, wobei in diesem Fall der dritte Kontakt 113 der Schnittstelle 11 als Masse-Potential dient. Im Gegensatz zu der gezeigten Darstellung kann die Steuer-Einheit 14 zur Generierung des entsprechenden Signals über ein separates IO-Link Modul verfügen, welches nur im Falle der Konfiguration der Schnittstelle 11 zur IO-Link basierten Übertragung aktiviert wird. Ansonsten kann auch bei dieser Konfiguration der Schnittstelle 11 die Steuer-Einheit 14 über den ersten Kontakt 111 durch die übergeordnete Einheit 4 mit Leistung versorgt werden. Bei dem in Fig. 2 gezeigten Ersatzschaltbild wird dies wiederum durch eine zweite Spannungsquelle Q₂ zwischen dem ersten Kontakt 111 und dem dritten Kontakt 113 repräsentiert. Die Schnittstelle 11 kann beispielsweise in Form einer M12-Steckverbindung oder einem vergleichbaren Steckverbindungs-Typ mit mindestens vier Kontakten ausgelegt sein.

Bei der Inbetriebnahme am Behälter 3 muss das Feldgerät 1 darauf konfiguriert sein, welcher der mindestens zwei potentiell möglichen Standards der Schnittstelle 11 zu nutzen ist. Darüber hinaus müssen die entsprechenden Kontakte 111-114 der Schnittstelle 11 korrekt kontaktiert sein. Ist dies nicht der Fall, so kann dies im schlimmsten Fall dazu führen, dass die falsche Verkabelung bzw. die falsche Konfiguration durch die übergeordnete Einheit 4 nicht erkannt wird und die übertragenen Signale vielmehr als Messwert interpretiert werden, welche jedoch den Messwert jedoch nicht korrekt widerspiegeln.

Erfindungsgemäß umfasst das Feldgerät 1 daher zudem einen zweiten Stromregler 13, der zwischen dem ersten Kontakt 111 und dem dritten Kontakt 113 der Schnittstelle 11 angeordnet ist. Hierdurch ist es möglich, einen zweiten Strom a₂ zwischen dem ersten Kontakt 111 und dem dritten Kontakt 113 einzustellen, sofern das Feldgerät 1 über die Schnittstelle 11 so kontaktiert ist, dass die übergeordnete Einheit 4 bzw. die zweite elektrische Spannungsquelle Q₂ zwischen diesen Kontakten 111, 113 angeschlossen ist. Dabei reicht als Stromstärke des zweiten Stroms a₂ bereits ein geringer Wert von beispielsweise 200µA. Sofern es mittels des zweiten Stromreglers 13 möglich ist, den zweiten Strom a₂ einzustellen, wird das Feldgerät 1 folglich so konfiguriert, dass es den Messwert bzw. weitere Parameter mittels des vordefinierten digitalen Protokolls wie dem IO-Link über den vierten Kontakt 114 überträgt.

In dem Fall, dass mittels des zweiten Stromreglers 13 der zweite Strom a₂ zwischen dem ersten Kontakt 111 und dem dritten Kontakt 113 eingestellt werden kann, wird dennoch auch der erste Stromregler 12 aktiviert, um sicherheitshalber zu prüfen, ob zwischen dem ersten Kontakt 111 für die Leistungsversorgung und dem zweiten Kontakt 112 für die Masse des ersten Stromsignals a₁ die übergeordnete Einheit 4 bzw. die erste elektrische Spannungsquelle Q₁ angeschlossen ist. Das Einschalten des ersten Stromreglers 12 kann in diesem Fall sehr zeitnah, beispielsweise 300 ms, nachdem der zweite Stromregler 13 den zweiten Strom a₂ zwischen dem ersten Kontakt 111 und dem dritten Kontakt 113 einstellt, erfolgen. Zur reinen Prüfung, ob zwischen dem ersten Kontakt 111 und dem dritten Kontakt 113 ein erster Strom a₁ eingestellt werden kann, muss dessen Stromstärke nicht zwangsweise dem Messwert gemäß dem 4-20 mA Standard entsprechen, sondern hierzu kann eine deutlich geringere Stromstärke von beispielsweise wiederum 200 µA gewählt werden.

Ergibt die Prüfung, dass mittels des ersten Stromreglers 12 der erste Strom a₁ nicht einstellbar ist, so wird dies als Bestätigung dafür interpretiert, dass nach wie vor die drei Kontakte 111, 113, 114 zur digitalen Datenübertragung mit der übergeordneten Einheit 4 verbunden sind. Dementsprechend bleibt die digitale Datenübertragung über den vierten Kontakt 114 aktiv. Dass der erste Strom a₁ nicht einstellbar ist, signalisiert der erste Stromregler 12 der Steuer-Einheit 14 mittels eines entsprechenden ersten Signals s_{f1}. Wenn der erste Stromregler 12 auf einem Operations-Verstärker basiert, kann die Steuer-Einheit 14 beispielweise das Steuer-Signal des Operations-Verstärkers als erstes Signal s_{f1} detektieren, falls der Operations-Verstärker in Sättigung arbeitet, also wenn vergeblich versucht wird, den ersten Strom a₁ einzustellen.

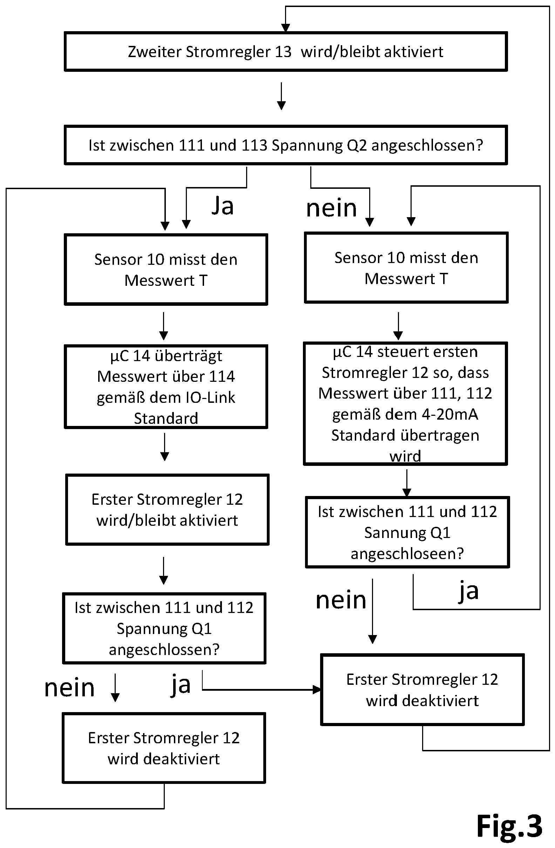

Sofern die Prüfung mittels des ersten Stromreglers 12 ergeben hat, dass der erste Strom a₁ nicht eingestellt werden kann und somit der Messwert nicht über die Kontakte 111, 112 zur analogen Datenübertragung übertragen werden soll, kann der erste Stromregler 12 in diesem Fall wieder deaktiviert werden. Schematisch dargestellt sind diese Verfahrens-Schritte in Fig. 3.

Wenn diese zuvor genannten Verfahrens-Schritte zyklisch wiederholt werden, solange zwischen dem ersten Kontakt 111 und dem dritten Kontakt 113 die zweite Spannungsquelle Q₂ angeschlossen ist, bzw. solange der erste Strom a₁ nicht einstellbar ist, kann die Steuer-Einheit 14 des Feldgerätes 1 detektieren, sobald sich dies ändert:
Erkennt die Steuer-Einheit 14 aufgrund des ausbleibenden ersten Signals s_{f1} des ersten Stromreglers 12, dass zwischen dem ersten Kontakt 111 und dem zweiten Kontakt 112 ab jetzt der erste Strom a₁ einstellbar ist, so folgert die Steuer-Einheit 14 hieraus, dass das Feldgerät 1 fortan so zu konfigurieren ist, dass nunmehr der Messwert über diese Kontakte 111, 112 zur analogen Messwertübertragung übermittelt werden soll. Als Überprüfung dessen wird (oder bleibt) jedoch zunächst wieder der zweite Stromregler 13 aktiviert, um zu verifizieren, dass tatsächlich kein zweiter Strom a₂ mehr zwischen dem ersten Kontakt 111 und dem dritten Kontakt 113 eingestellt werden kann. Bei entsprechender Verifikation, wenn also der zweite Stromregler 13 ein korrespondierendes Signal s_{f2} an die Steuer-Einheit 14 übermittelt, steuert die Steuer-Einheit 14 den ersten Stromregler 12 so, dass der erste Strom a₁ gemäß dem 4-20 mA Standard dem vom Sensor 10 gemessenen Messwert entspricht.

Zusammenfassend dargestellt ist dieses erfindungsgemäße Verfahren in Fig. 3: Vorteilhaft ist hieran, dass durch die zwei Stromregler 12, 13 quasi redundant geprüft wird, über welche der Kontakte 111-114 das Feldgerät 1 mit der übergeordneten Einheit 4 kontaktiert ist, so dass der entsprechende Übertragungs-Standard eingestellt werden kann. Zum anderen wird durch die zyklische Wiederholung der Verfahrens-Schritte sichergestellt, dass das Feldgerät 1 eine Änderung der Kontaktierung auch während des Messbetriebs feststellten und automatisch reagieren kann, ohne dass die Konfiguration des Feldgerätes 1 manuell geändert werden muss. Dies erhöht zusätzlich die Sicherheit der gesamten Prozess-Anlage.

### Bezugszeichenliste

- 1: Feldgerät
- 2: Füllgut
- 3: Behälter
- 4: Übergeordnete Einheit
- 10: Sensor
- 11: Schnittstelle
- 12: Erster Stromregler
- 13: Zweiter Stromregler
- 14: Steuer-Einheit
- 111: Erster Kontakt
- 112: Zweiter Kontakt
- 113: Dritter Kontakt
- 114: Vierter Kontakt
- 141: Strom-Messgerät
- a₁: Erster Strom
- a₂: Zweiter Strom
- Q₁: Erste Spannungsquelle
- Q₂: Zweite Spannungsquelle
- s_{f1}: Erstes Signal
- s_{f2}: Zweites Signal

## Patentansprüche

1. Feldgerät zur Messung einer Messgröße, umfassend:
- Einen Sensor (10), der ausgelegt ist, den entsprechenden Messwert zu messen,
- eine Schnittstelle (11) mit zumindest vier elektrischen Kontakten (111-114),
- einen ersten Stromregler (12), der ausgelegt ist,
o einen ersten Strom (a₁) zwischen dem ersten Kontakt (111) und dem zweiten Kontakt (112) einzustellen, sofern das Feldgerät (1) über die Schnittstelle (11) so kontaktiert ist, dass zwischen diesen Kontakten (111, 112) eine erste Spannungsquelle (Q₁) angeschlossen ist,
**dadurch gekennzeichnet, dass** das Feldgerät weiterhin umfasst
- einen zweiten Stromregler (13), der ausgelegt ist,
o einen zweiten Strom (a₂) zwischen dem ersten Kontakt (111) und dem dritten Kontakt (113) einzustellen, sofern das Feldgerät (1) über die Schnittstelle (11) so kontaktiert ist, dass zwischen diesen Kontakten (111, 113) eine zweite elektrische Spannungsquelle (Q₂) angeschlossen ist,
o im anderen Fall ein zweites Signal (s_{f2}) zu generieren, und
- eine Steuer-Einheit (14), die ausgelegt ist,
o den Messwert gemäß einem vordefinierten digitalen Standard über den vierten Kontakt (114) zu übertragen, sofern der zweite Strom (a₂) zwischen dem ersten Kontakt (111) und dem dritten Kontakt (113) einstellbar ist, und
o den ersten Stromregler (12) derart zu steuern, dass die Stromstärke des ersten Stroms (a₁) dem Messwert gemäß einem vordefinierten Stromsignal-Standard entspricht, sofern der zweite Stromregler (13) das zweite Signal (s_{f2}) generiert.

2. Feldgerät nach Anspruch 1, wobei der erste Stromregler (12) ausgelegt ist, ein erstes Signal (s_{f1}) zu generieren, sofern das Feldgerät (1) derart kontaktiert ist, dass zwischen dem ersten Kontakt (111) und dem zweiten Kontakt (112) keine elektrische Spannungsquelle (Q₁) angeschlossen ist.

3. Feldgerät nach Anspruch 1 oder 2, wobei je nach Kontaktierung der Schnittstelle (11) die erste Spannungsquelle (Q₁) oder die zweite Spannungsquelle (Q₂), den ersten Stromregler (12), den zweiten Stromregler (13) und/oder die Steuer-Einheit (14) mit Leistung versorgt.

4. Feldgerät nach Anspruch 3, wobei der erste Stromregler (12) zur Regelung der Stromstärke des ersten Stroms (a₁) einen steuerbaren Operations-Verstärker umfasst, und wobei die Steuer-Einheit (14) ausgelegt ist, ein Steuer-Signal des Operations-Verstärkers als erstes Signal (s_{f1}) zu detektieren, sofern der Operations-Verstärker in Sättigung arbeitet.

5. Feldgerät nach einem der vorhergehenden Ansprüche, wobei in der Steuer-Einheit (14) als digitaler Standard zur Übertragung des Messwertes über den vierten Kontakt (114) der IO-Link Standard implementiert ist.

6. Feldgerät nach einem der vorhergehenden Ansprüche, wobei in der Steuer-Einheit (14) als Standard zur Stromsignal-basierten Übertragung des Messwertes über den ersten Kontakt (111) bzw. den zweiten Kontakt (112) der 4-20 mA Standard implementiert ist.

7. Feldgerät nach zumindest einem der vorhergehenden Ansprüche, wobei die Schnittstelle (11) als M12-Steckverbindung ausgelegt ist.

8. Verfahren zur Übertragung eines Messwertes von einem Feldgerät (1) nach einem Ansprüche 1 bis 7, folgende Verfahrensschritte umfassend:
- Messung des Messwertes,
- Einstellung des zweiten Stroms (a₂) zwischen dem ersten Kontakt (111) und dem dritten Kontakt (113), sofern das Feldgerät (1) über die Schnittstelle (11) so kontaktiert ist, dass zwischen diesen Kontakten (111, 112) eine zweite elektrische Spannungsquelle (Q₂) angeschlossen ist, und andernfalls
- Generierung des zweiten Signals (s_{f2}),
- Übertragung des Messwertes gemäß einem vordefinierten digitalen Protokoll über den vierten Kontakt (114), sofern das zweite Signal (s_{f2}) nicht generiert wird,
- Einstellung des ersten Stroms (a₁) zwischen dem ersten Kontakt (111) und dem zweiten Kontakt (112), sofern das Feldgerät (1) über die Schnittstelle (11) so kontaktiert ist, dass zwischen diesen Kontakten (111, 112) eine erste elektrische Spannungsquelle (Q₁) angeschlossen ist, und andernfalls
- Generierung des ersten Signals (s_{f1}),
wobei die Verfahrensschritte zyklisch wiederholt werden, sofern das erste Signal (s_{f1}) nicht generiert wird, und
wobei im anderen Fall die Messung des Messwertes, die Übertragung des Messwertes gemäß dem vordefinierten digitalen Protokoll über den vierten Kontakt (114), die Einstellung des ersten Stroms (a₁) und die etwaige Generierung des ersten Signals (s_{f1}) wiederholt werden.

9. Verfahren nach Anspruch 8, folgende zusätzliche Verfahrensschritte umfassend:
- derartige Steuerung des ersten Stromreglers (12), so dass die Stromstärke des ersten Stroms (a₁) gemäß dem vordefinierten Stromsignal-Standard dem Messwert entspricht, sofern das zweite Signal (s_{f2}) generiert wird,
wobei die Verfahrensschritte zyklisch wiederholt werden, sofern das erste Signal (s_{f1}) generiert wird, und
wobei im anderen Fall die Messung des Messwertes und die Steuerung des ersten Stromreglers (12), so dass die Stromstärke des ersten Stroms (a₁) gemäß dem vordefinierten Stromsignal-Standard dem Messwert entspricht, wiederholt werden.

10. Verfahren nach Anspruch 8 oder 9, wobei der erste Strom (a₁) maximal 300 ms, nachdem der zweite Stromregler (13) den zweiten Strom (a₂) zwischen dem ersten Kontakt (111) und dem dritten Kontakt (113) einstellt, zwischen dem ersten Kontakt (111) und dem zweiten Kontakt (112) eingestellt wird.

## Claims

1. A field device for measuring a measurement variable, comprising:
- a sensor (10), which is designed to measure the corresponding measured value;
- an interface (11) having at least four electrical contacts (111-114);
- a first current regulator (12), which is designed
o to set a first current (a₁) between the first contact (111) and the second contact (112) when the field device (1) is contacted via the interface (11) such that a first voltage source (Q₁) is connected between these contacts (111, 112),
**characterized in that** the field device furthermore comprises
- a second current regulator (13), which is designed
o to set a second current (a₂) between the first contact (111) and the third contact (113) when the field device (1) is contacted via the interface (11) such that a second electrical voltage source (Q₂) is connected between these contacts (111, 113), and
o in the other case to generate a second signal (s_{f2}); and
- a control unit (14), which is designed:
o to transmit the measured value according to a predefined digital standard via the fourth contact (114) when the second current (a₂) is settable between the first contact (111) and the third contact (113), and
o to control the first current regulator (12) such that the current strength of the first current (a₁) corresponds to the measured value according to a predefined current signal standard when the second current regulator (13) generates the second signal (s_{f2}).

2. The field device as claimed in claim 1, wherein the first current regulator (12) is designed to generate a first signal (s_{f1}) when the field device (1) is contacted in such a way that no electrical voltage source (Q₁) is connected between the first contact (111) and the second contact (112).

3. The field device as claimed in claim 1 or 2, wherein, depending on contacting of the interface (11), the first voltage source (Q₁) or the second voltage source (Q₂) supplies the first current regulator (12), the second current regulator (13) and/or the control unit (14) with power.

4. The field device as claimed in claim 3, wherein the first current regulator (12) comprises a controllable operational amplifier for controlling the current strength of the first current (a₁), and wherein the control unit (14) is designed to detect a control signal of the operational amplifier as first signal (sn) when the operational amplifier is operating in saturation.

5. The field device as claimed in any one of the preceding claims, wherein the IO-Link standard is implemented in the control unit (14) as a digital standard for transmitting the measured value via the fourth contact (114).

6. The field device as claimed in any one of the preceding claims, wherein the 4-20 mA standard is implemented in the control unit (14) as a standard for current-signal-based transmission of the measured value via the first contact (111) or the second contact (112).

7. The field device as claimed in at least one of the preceding claims, wherein the interface (11) is designed as an M12 plug connection.

8. A method for transmitting a measured value from a field device (1) as claimed in any one of claims 1 to 7, comprising the following method steps:
- measuring the measured value;
- setting the second current (a₂) between the first contact (111) and the third contact (113) when the field device (1) is contacted via the interface (11) such that a second electrical voltage source (Q₂) is connected between these contacts (111, 112), and otherwise
- generating the second signal (s_{f2}),
- transmitting the measured value according to a predefined digital protocol via the fourth contact (114) when the second current (s_{f2}) is not generated,
- setting the first current (a₁) between the first contact (111) and the second contact (112) when the field device (1) is contacted via the interface (11) such that a first electrical voltage source (Q₁) is connected between these contacts (111, 112), and otherwise
- generating the first signal (s_{f1}),
wherein the method steps are cyclically repeated when the first signal (sn) is not generated, and
wherein, in the other case, the measurement of the measured value, the transmission of the measured value according to the predefined digital protocol via the fourth contact (114), the setting of the first current (a₁), and the possible generation of the first signal (sn) are repeated.

9. The method as claimed in claim 8, comprising the following additional method steps:
- controlling the first current regulator (12) such that the current strength of the first current (a₁) corresponds to the measured value according to the predefined current signal standard when the second signal (s_{f2}) is generated,
wherein the method steps are cyclically repeated when the first signal (s_{f1}) is generated, and wherein, in the other case, the measurement of the measured value and the control of the first current regulator (12) are repeated, such that the current strength of the first current (a₁) corresponds to the measured value according to the predefined current-signal standard.

10. The method as claimed in claim 8 or 9, wherein the first current (a₁) between the first contact (111) and the second contact (112) is set at a maximum of 300 ms after the second current regulator (13) sets the second current (a₂) between the first contact (111) and the third contact (113).

## Revendications

1. Appareil de terrain destiné à la mesure d'une grandeur de mesure, lequel appareil comprend :
- un capteur (10), lequel est conçu pour mesurer la valeur mesurée correspondante,
- une interface (11) avec au moins quatre contacts électriques (111-114),
- un premier régulateur de courant (12), lequel est conçu pour
o régler un premier courant (a₁) entre le premier contact (111) et le deuxième contact (112), dans la mesure où l'appareil de terrain (1) est mis en contact par l'intermédiaire de l'interface (11) de telle sorte qu'une première source de tension (Q₁) est connectée entre ces contacts (111, 112),
**caractérisé en ce que** l'appareil de terrain comprend en outre
- un deuxième régulateur de courant (13), lequel est conçu pour
o régler un deuxième courant (a₂) entre le premier contact (111) et le troisième contact (113), dans la mesure où l'appareil de terrain (1) est mis en contact par l'intermédiaire de l'interface (11) de telle sorte qu'une deuxième source de tension électrique (Q₂) est connectée entre ces contacts (111, 113),
o dans le cas contraire, à générer un deuxième signal (s_{f2}), et
- une unité de commande (14), laquelle est conçue pour
o transmettre la valeur mesurée selon une norme numérique prédéfinie par l'intermédiaire du quatrième contact (114), dans la mesure où le deuxième courant (a₂) est réglable entre le premier contact (111) et le troisième contact (113), et pour
o commander le premier régulateur de courant (12) de telle sorte que l'intensité du premier courant (a₁) correspond à la valeur mesurée selon une norme de signal de courant prédéfinie, dans la mesure où le deuxième régulateur de courant (13) génère le deuxième signal (s_{f2}).

2. Appareil de terrain selon la revendication 1, pour lequel le premier régulateur de courant (12) est conçu pour générer un premier signal (s_{f1}), dans la mesure où l'appareil de terrain (1) est mis en contact de telle sorte qu'aucune source de tension électrique (Q₁) n'est raccordée entre le premier contact (111) et le deuxième contact (112).

3. Appareil de terrain selon la revendication 1 ou 2, pour lequel, en fonction de la mise en contact de l'interface (11), la première source de tension (Q₁) ou la deuxième source de tension (Q₂) alimente en énergie le premier régulateur de courant (12), le deuxième régulateur de courant (13) et/ou l'unité de commande (14).

4. Appareil de terrain selon la revendication 3,
pour lequel le premier régulateur de courant (12) comprend un amplificateur opérationnel commandable pour la régulation de l'intensité du premier courant (a₁), et
pour lequel l'unité de commande (14) est conçue pour détecter un signal de commande de l'amplificateur opérationnel en tant que premier signal (s_{f1}), dans la mesure où l'amplificateur opérationnel fonctionne en saturation.

5. Appareil de terrain selon l'une des revendications précédentes, pour lequel la norme IO-Link est implémentée dans l'unité de commande (14) comme norme numérique pour la transmission de la valeur mesurée via le quatrième contact (114).

6. Appareil de terrain selon l'une des revendications précédentes, pour lequel la norme 4-20 mA est implémentée dans l'unité de commande (14) comme norme pour la transmission basée sur un signal de courant de la valeur mesurée via le premier contact (111) ou le deuxième contact (112).

7. Appareil de terrain selon au moins l'une des revendications précédentes, pour lequel l'interface (11) est conçue comme une connexion enfichable M12.

8. Procédé destiné à la transmission d'une valeur mesurée par un appareil de terrain (1) selon l'une des revendications 1 à 7, lequel procédé comprend les étapes suivantes :
- Mesure de la valeur mesurée,
- Réglage du deuxième courant (a₂) entre le premier contact (111) et le troisième contact (113), dans la mesure où l'appareil de terrain (1) est mis en contact via l'interface (11) de telle sorte qu'une deuxième source de tension électrique (Q₂) est connectée entre ces contacts (111, 112), et sinon
- Génération du deuxième signal (s_{f2}),
- Transmission de la valeur mesurée selon un protocole numérique prédéfini via le quatrième contact (114), dans la mesure où le deuxième signal (s_{f2}) n'est pas généré,
- Réglage du premier courant (a₁) entre le premier contact (111) et le deuxième contact (112), dans la mesure où l'appareil de terrain (1) est mis en contact via l'interface (11) de telle sorte qu'une première source de tension électrique (Q₁) est connectée entre ces contacts (111, 112), et sinon
- Génération du premier signal (s_{f1}),
les étapes de procédé étant répétées de manière cyclique dans la mesure où le premier signal (s_{f1}) n'est pas généré, et
dans le cas contraire, la mesure de la valeur mesurée, la transmission de la valeur mesurée selon le protocole numérique prédéfini via le quatrième contact (114), le réglage du premier courant (a₁) et la génération éventuelle du premier signal (s_{f1}) étant répétés.

9. Procédé selon la revendication 8, lequel procédé comprend les étapes supplémentaires suivantes :
- Commande du premier régulateur de courant (12) de telle sorte que l'intensité du premier courant (a₁) corresponde à la valeur mesurée selon la norme de signal de courant prédéfinie, dans la mesure où le deuxième signal (s_{f2}) est généré,
les étapes de procédé étant répétées de manière cyclique dans la mesure où le premier signal (s_{f1}) est généré ; et
dans le cas contraire, la mesure de la valeur mesurée et la commande du premier régulateur de courant (12) étant répétées de telle sorte que l'intensité du premier courant (a₁) correspond à la valeur mesurée conformément à la norme de signal de courant prédéfinie.

10. Procédé selon la revendication 8 ou 9, pour lequel le premier courant (a₁) est réglé entre le premier contact (111) et le deuxième contact (112) au maximum 300 ms après que le deuxième régulateur de courant (13) a réglé le deuxième courant (a₂) entre le premier contact (111) et le troisième contact (113).
